(19) Europäisches Patentamt
European Patent Office
Office européen des brevets

(11) EP 2 399 676 A1

(12) EUROPEAN PATENT APPLICATION

(43) Date of publication:
28.12.2011 Bulletin 2011/52

(51) Int Cl.:
B06B 1/00 (2006.01)   H01L 41/113 (2006.01)

(21) Application number: 10167267.3

(22) Date of filing: 25.06.2010

(84) Designated Contracting States:
AL AT BE BG CH CY CZ DE DK EE ES FI FR GB
GR HR HU IE IS IT LI LT LU LV MC MK MT NL NO
PL PT RO SE SI SK SM TR
Designated Extension States:
BA ME RS

(71) Applicant: Stichting IMEC Nederland
5656 AE Eindhoven (NL)

(72) Inventors:
• Matova, Svetla
5582 CE, Waalre (NL)
• Elfrink, Rene
5582 HH, Waalre (NL)
• Vullers, Ruud
5581 CS, Waalre (NL)

(74) Representative: Hertoghe, Kris Angèle Louisa et al
DenK iP bvba
Hundelgemsesteenweg 1114
9820 Merelbeke (BE)

(54) **Method and device for vibration harvesting via gasflow**

(57) The present invention provides a device for gasflow, e.g. airflow, energy harvesting. Such device according to embodiments of the present invention comprises a cavity resonator such as a Helmholtz resonator comprising a membrane for converting gasflow in vibration, and a vibrational energy harvester for converting the converted vibration into electrical energy. The device for gasflow energy harvesting is adapted such that the movement of the vibrational energy harvester is decoupled from the movement of the membrane. This allows to obtain a good output power of e.g. more than 10 μW.

FIG. 4

EP 2 399 676 A1

## Description

### Field of the invention

The present invention relates to the field of vibration harvesting, for example for powering of wireless sensors and low power devices. More particularly, the present invention relates to the field of harvesting energy from gasflow, e.g. airflow (such as wind) with micro machined (MEMS) vibrational energy harvesters.

### Background of the invention

The oldest known way to extract energy from airflow is by using wind turbines. Although large-scale wind turbines can be highly efficient, performance of miniature wind turbines is less efficient due to the relatively high viscous drag on the blades at low Reynolds numbers and the bearing losses. Operation at very low flow velocities, e.g. about 1m/s, and miniature turbines for wireless sensor systems require turbines with a very low-friction bearing. For such applications, devices without bearings are a better solution.

Because direct conversion of gasflow into useful energy cannot be done using micromachined devices, harvesters of gasflow energy have been developed in recent years based on vibrational energy harvesters, such as piezo-electric or magneto-electric harvesters. These gasflow harvesters rely on the drag force of the gasflow, which causes vibration of a piezoelectric component or magneto-electric component, which in turn converts kinetic energy of motion into electricity.

US2006/022555 describes an energy harvesting device, system and method. The energy harvester collects acoustic energy and transforms it into electrical energy. The energy harvester utilizes an acoustic chamber configured to collect acoustic energy, a back plate in connection with the acoustic chamber and configured to convert the collected acoustic energy into mechanical energy, and a piezoelectric device mounted on the back plate and configured to convert the mechanical energy into electrical energy. The piezoelectric device is coupled on the one hand to a membrane converting the gasflow energy into vibrations in a cavity, and on the other hand to a wall of the acoustic chamber. By this coupling, the amplitude of the movement of the back plate is equal to the amplitude of the movement of the piezoelectric device.

It is a disadvantage of known devices that they only have a limited output power. The reported energies generated by such harvesters are relatively small, e.g. less than 10 $\mu$W.

### Summary of the invention

It is an object of embodiments of the present invention to provide a method and device for harvesting energy from gasflow, e.g. airflow such as wind, with micromachined (MEMS) vibrational energy harvesters, which provide a good output power.

The above objective is accomplished by a method and device according to the present invention.

In a first aspect, the present invention provides a device for gasflow, e.g. airflow, energy harvesting. Such device according to embodiments of the present invention comprises

a cavity resonator comprising a membrane for converting gasflow in vibration, and

a vibrational energy harvester for converting the converted vibration into electrical energy,

wherein the device for gasflow energy harvesting is adapted such that the movement of the vibrational energy harvester is decoupled from the movement of the membrane.

A cavity resonator is a resonator in which waves exist in a hollow space, the cavity, inside the device. A particular type of cavity resonator which may be used in embodiments of the present invention is a Helmholtz resonator, in which air vibrates in a cavity with one opening. The Helmholtz resonator may for example be a tube closed with a membrane at one side and having an opening at the other side, or a bottle with a membrane at the bottom.

It is an advantage of a device for gasflow energy harvesting according to embodiments of the present invention that it provides a good power output, e.g. a power output of 20 $\mu$W or higher, for example a power output of 50 $\mu$W or higher, or even a power output of 100 $\mu$W or higher.

In a device for gasflow energy harvesting according to embodiments of the present invention, the movement of the vibrational energy harvester may be decoupled from the movement of the membrane by mounting a separately movable vibrational energy harvester on the membrane of the cavity resonator. This way, due to the mounting on the membrane, the vibrational energy harvester may be actuated by the membrane movements. Nevertheless, due to the decoupling of the movements of the membrane from the movements of the vibrational harvester, the amplitude and/or frequency of movement of the vibrational energy harvester may be different from the amplitude and/or frequency of movement of the membrane. It is advantageous if the frequency of movement of the membrane corresponds to the resonance frequency of the vibrational energy harvester, because in that case maximum energy may be harvested.

The amplitude of the movement of the membrane may be different from the amplitude of the movement of the vibrational energy harvester, for example the amplitude of movement of the vibrational energy harvester may be larger than the amplitude of movement of the membrane, which may be advantageous for efficiency of energy harvesting.

According to embodiments of the present invention, the vibrational energy harvester may be any suitable type of energy harvester, for example a piezoelectric, electromagnetic or electrostatic device. In particular piezoelectric harvesters such as piezo-membranes or piezo-electric cantilevers may be used.

In accordance with particular embodiments of the present invention, the vibrational energy harvester, e.g. piezoelectric harvester, may be vacuum packaged. This is advantageous, as it provides improved power output because the movement of the harvester is not damped by surrounding air. It is a further advantage of using a vacuum packaged harvester that such harvester can be mounted at any side of the membrane, hence also where ambient air is present. Moreover, the space underneath the membrane does not need to be vacuum, hence no complex vacuum assembling techniques are required.

In accordance with alternative embodiments of the present invention, the vibrational energy harvester, e.g. piezoelectric harvester, may be gas-packaged, e.g. air-packaged. This may be advantageous as it avoids destruction of the harvester due to too large movements.

The vibrational energy harvester according to embodiments of the present invention may comprise a cantilever beam. The cantilever beam may be made of or covered with piezoelectric material.

In embodiments of the present invention, the membrane may be a soft membrane, soft being defined as having a spring constant much less than the spring constant of the vibrational energy harvester, for example at least 20% less, e.g. at least 50% less. In case the vibrational energy harvester comprises a cantilever beam, the membrane is considered soft if it's spring constant is much less, for example at least 20% less, e.g. at least 50% less, than the spring constant of the cantilever beam, which latter spring constant is determined by design application. An advantage of using a soft membrane is that it is easily actuatable by means of the gas flow.

In particular embodiments, the vibrational energy harvester and the cavity resonator have a similar resonance frequency, e.g. resonance frequencies which do not differ more than 5%, e.g. not more than 1%. The better the resonance frequencies are matched, the better the energy output obtained.

It is particularly advantageous to provide a cavity resonator which is adapted for having an adjustable resonance frequency. This way, the resonance frequency of the cavity resonator may be adapted depending on the resonance frequency of the vibrational energy harvester, which may for example differ from design specs due to inconsistencies in fabrication. The adaptation may consist of making the resonance frequency of the cavity resonator substantially equal to, e.g. differing not more than 5%, for example not more than 1%, the resonance frequency of the vibrational energy harvester.

The cavity resonator has a cavity, and may be adapted, according to embodiments of the present invention, for changing the volume of the cavity for obtaining the adaptation of the resonance frequency of the cavity resonator.

In accordance with embodiments of the present invention, the vibrational energy harvester may be a MEMS device. Hence embodiments of the present invention allow for miniaturisation of harvester devices. In particular embodiments of the present invention, the vibrational harvester may be an AIN piezoelectric harvester on the membrane.

In a second aspect, the present invention provides a method for harvesting energy from a gasflow by means of a vibrational energy harvester, the method comprising

converting the gasflow into vibrations of gas in a cavity, and

actuating the vibrational energy harvester by means of the vibrations of gas in the cavity,

wherein actuating the vibrational energy harvester is such that the amplitude of the movement of the vibrational energy harvester is decoupled from the amplitude of the movement of the gas vibrations.

Particular and preferred aspects of the invention are set out in the accompanying independent and dependent claims. Features from the dependent claims may be combined with features of the independent claims and with features of other dependent claims as appropriate and not merely as explicitly set out in the claims.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

**Brief description of the drawings**

FIG. 1 illustrates in (a) and (b) the principle of Helmholtz resonance, and in (c) a mass-spring representation.

FIG. 2 schematically illustrates a principle of operation according to embodiments of the present invention, where a vibrational energy harvester is mounted on top of a membrane.

FIG. 3 shows results of a simulation of the pressure distribution in a bottle, used as Helmholtz resonator (graph taken from D. O. Ludwigsen et al., "Better Understanding of Resonance through Modeling and Visualisation", Proceedings of the COMSOL Users Conference 2006, Boston).

FIG. 4 is a schematic illustration of a device for gasflow energy harvesting according to an embodiment of the present invention.

FIG. 5 is a schematic representation of a Helmholtz resonator with adjustable resonance frequency

FIG. 6 is a generic representation of a vibration energy harvester. The harvester consists of a spring, a mass that oscillates by the input vibrations and two dampers that represent the mechanical and electrical damping.

FIG. 7 shows a piezoelectric energy harvester packaged in between glass substrates. The mass can move up- and downwards.

FIG. 8 illustrates the dependence of the frequency of the Helmholtz resonator on the temperature of the gas and the volume of the cavity.

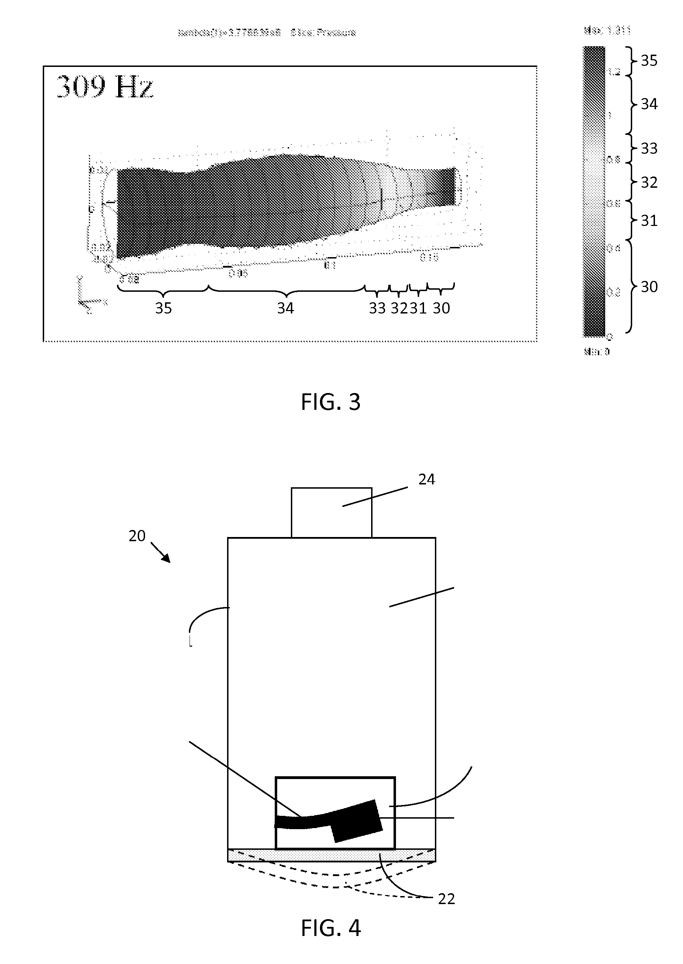

The drawings are only schematic and are non-limiting. In the drawings, the size of some of the elements may be exaggerated and not drawn on scale for illustrative purposes. In particular the size of the cantilever in FIG. 4 is exaggerated for purposes of illustration.

Any reference signs in the claims shall not be construed as limiting the scope.

In the different drawings, the same reference signs refer to the same or analogous elements.

## Detailed description of illustrative embodiments

Devices that convert different types of energy obtained from a system into electrical energy are known as "energy harvesters". Such devices attract increasing research interest today. The present invention relates to the field of vibration harvesting. Devices for vibration harvesting as in accordance with embodiments of the present invention may be used in, a.o. but not limited thereot, following applications:

- Sensor systems: for example for powering wireless sensor systems.
- Air conditioning pipes: Helmholtz resonators are used in air pipes to cut off the unwanted resonance frequencies of the pipes.
- Automobile or motorbike mufflers.

The idea behind embodiments of the present invention is to use a cavity resonator, e.g. Helmholtz resonator, as an indirect vibration source by converting gasflow, e.g. airflow, into vibrations of air in a cavity. The vibration in the cavity can then be used to excite a vibrational energy harvester. The cavity resonator can be designed of the size of a MEMS-packaging. With this embodiment, energy harvesting from airflow with micromachined harvesters is possible.

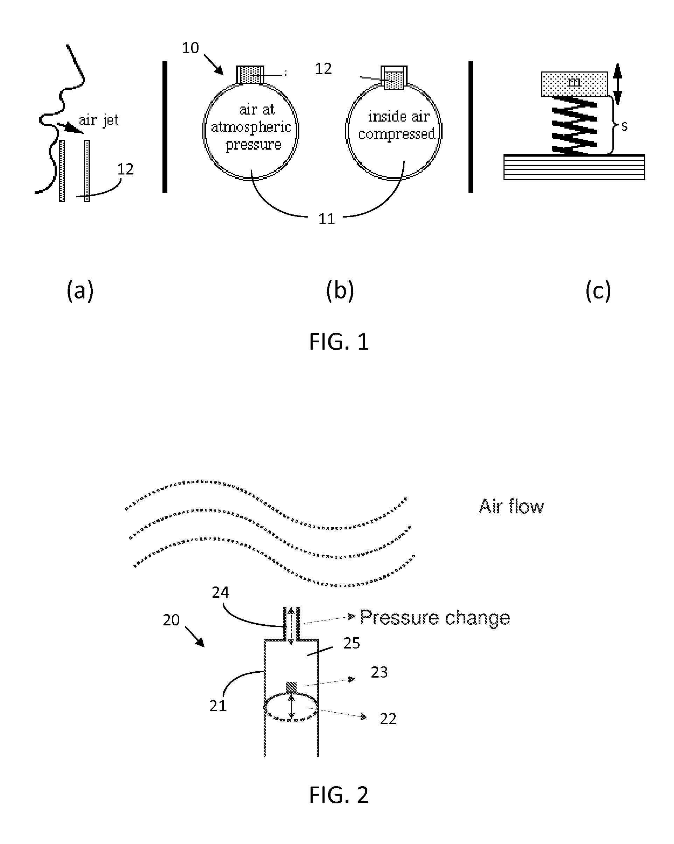

As an example of embodiments of the present invention, a Helmholtz resonator may be used as a particular cavity resonator. A Helmholtz resonator 10 is a resonator where Helmholtz resonance takes place. Helmholtz resonance is the phenomenon of gas, e.g. air, resonance in a cavity 11. An example of Helmholtz resonance is the sound created when one blows across the top of an empty bottle as illustrated in FIG. 1(a). The resonance frequency $f_H$ depends on the volume of the cavity 11 and the volume of the aperture (the neck 12) of the cavity 11:

$$f_H = \frac{v}{2\pi} \sqrt{\frac{A}{V_0 L'}} \qquad \text{Eq. (1)}$$

where v is the speed of sound in a gas filing the Helmholtz resonator 10, A is the cross sectional area of the neck 12, L' is the apparent length of the neck 12 and $V_0$ is the static volume of the cavity 11. Helmholtz resonators resonate at a fixed frequency which is easy to determine via the volume of the neck 12 and the cavity 11. The amplitude of the resonance depends on the gasflow, e.g. airflow, velocity. For a schematic representation of a Helmholtz resonator 10, see FIG. 1(b). The apparent length L' of the neck 12 includes the actual length of the neck 12 with correction for the extra inertial mass of gas, e.g. air, around the neck region. As an example, the apparent length L' is given by

$$L' = L + 1.7r \qquad \text{Eq. (2)}$$

for a flanged aperture (slendering aperture), where r is the inside radius of the neck 11.

A Helmholtz resonator can be represented as a simple mass-spring system, as illustrated in FIG. 1(c), where the mass m corresponds to the volume of the gas, e.g. air, in the neck 11 of the resonator 10 and the spring s corresponds to the volume of the gas, e.g. air, in the cavity 11 of the resonator 10.

The inertia of the gas, e.g. air, in the neck 11 is proportional to the apparent length L' of the neck 11. A longer neck 11 would make a larger mass m, and vice versa. The spring constant of the gas, e.g. air, in the cavity 11 is inversely proportional to its volume. A larger cavity 11 would make a weaker spring, and vice versa. Increasing the area of the neck 12 increases the inertia of the gas, e.g. air, proportionately, but also decreases the velocity at which the gas, e.g. air, rushes in and out the cavity 11.

Generally the cavity 11 has several resonance frequencies, lowest of which is the Helmholtz resonance. The pressure in the cavity 11 is relatively uniform, and the gas, e.g. air, in the neck 12 oscillates as a single mass.

When gas, e.g. air, is blown above the opening, as illustrated at the right hand side of FIG. 1(b), the airflow presses the gas, e.g. air, in the neck 11 into the cavity 10. The gas, e.g. air, in the cavity 10 is compressed and reacts in opposite direction pushing the gas, e.g. air, in the neck 11 back. This surge of gas, e.g. air, flowing out will tend to over-compensate, due to the inertia of the gas, e.g. air, in the neck 11, and the cavity 10 will be left at a pressure slightly lower than the outside, causing gas, e.g. air, to be drawn back in. This process repeats with the magnitude of the pressure changes decreasing each time. A constant gasflow is required, in order to keep the cavity resonating.

Distinctive feature of the Helmholtz resonators is their accurate resonance frequency.

In a first embodiments of the present invention, a device 20 for gasflow, e.g. airflow, energy harvesting is provided. An embodiment of a device 20 for gasflow energy harvesting according to the present invention is schematically illustrated in FIG. 2, and comprises a Helmholtz resonator 21 for converting gasflow, e.g. airflow, into air pressure oscillation with certain amplitude of oscillation, a membrane 22 to locally translate and enhance the air oscillation amplitude into mechanical vibration amplitude and a vibrational energy harvester 23 for converting the converted air pressure oscillation into electrical energy. The device 20 for gasflow energy harvesting is adapted such that the amplitude of movement of the package of the vibrational energy harvester 23 is the same as the amplitude of movement of the membrane 22, but the amplitude of movement of the electrical energy converter thereof can differ.

This may be obtained for example according to embodiments of the present invention by implementing the vibrational energy harvester 23 as a piezoelectric harvester. One example of a piezoelectric harvester may for example be a piezoelectric cantilever, comprising a beam 40 and a mass 41, the beam 40 being provided from or covered with piezoelectric material such as for example PZT (Lead Zirconate Titanate), PDVF (Polyvinylidene fluoride), $BaTiO_3$ (Barium titanate), $PbTiO_3$ (Lead titanate) or AIN (Aluminum Nitride), for converting mechanical strain into electrical current or voltage. The beam 40 and mass 41 are not attached directly onto the membrane 22, so that they can move independently from the movement of the membrane 22. With moving independently is meant that the amplitude of the mass 41 does not necessarily have the same amplitude as the movement of the membrane 22. The beam 40 and mass 41 may be mounted movable in a housing, which housing may be attached to the membrane 22.

Another example of a piezoelectric harvester may for example be a piezo-membrane. Also the piezo-membrane in accordance with embodiments of the present invention is attached onto the membrane 22 in such a way that the piezo-membrane can move independently from the movement of the membrane 22, e.g. via a housing. The piezo-membrane may be packaged, for example in a vacuum packaging or in gas-packaging, e.g. air-packaging.

According to other embodiments of the present invention, the vibrational energy harvester 23 may be an electromagnetic harvester or an electrostatic device. An example of an electromagnetic harvester which may be used in embodiments of the present invention is a permanent magnet/coil system. The permanent magnet may be mounted on a carrier, for example a beam, which is mounted on the membrane 22 such that the movement of the magnet and the movement of the membrane 22 are decoupled from one another. The magnet is mounted such that it's movement with respect to the coil generates electrical power.When the membrane 22 moves under influence of gas, e.g. air, pressure inside the Helmholtz resonator 21, generated by gas, e.g. air, flowing over the neck 24 of the resonator 21, this membrane 22 actuates the vibrational energy harvester 23. However, as, in accordance with embodiments of the present invention, the piezoelectric cantilever is not attached directly onto the membrane 22, its movement is decoupled from the movement of the membrane 22. With "decoupled" is meant that the movement of the mass 41 and the membrane 22 can have an amplitude and/or a frequency which are different one from the other. In accordance with embodiments of the present invention, the amplitude of movement of the membrane 22 and the amplitude of movement of the mass 41 of the vibrational harvester 23 can differ over a factor 100 to 1000.

It is particularly advantageous if the resonance frequency of the cavity resonator, e.g. Helmholtz resonator 21, and the resonance frequency of the vibrational energy harvester 23 coincide, as this generates maximum energy. The membrane 22 itself and the vibrational energy harvester 23 do not have to have the same resonance frequency. The membrane resonates with the resonance frequency of the cavity 25.

In view of efficiency, it is particularly advantageous to place the membrane 22 at the bottom of the Helmholtz resonator 21. This can be seen from FIG. 3, illustrating pressure distribution in a bottle used as a Helmholtz resonator (illustration taken from D.O. Ludwigsen et al., "Better understanding of resonance through modeling and visualization", Proceedings of the COMSOL Users Conference 2006, Boston). Different pressure regions are indicated in FIG. 3 by reference numbers 30 to 35, whereby increasing region numbers refer to regions with increasing pressure. Hence it can be seen from FIG. 3 that the pressure in a Helmholtz resonator 21 is highest at the bottom, i.e. at that side of the cavity remote from the neck 24, suggesting that the bottom of the cavity 25 would be the best place to place the vibrational energy harvester 23.

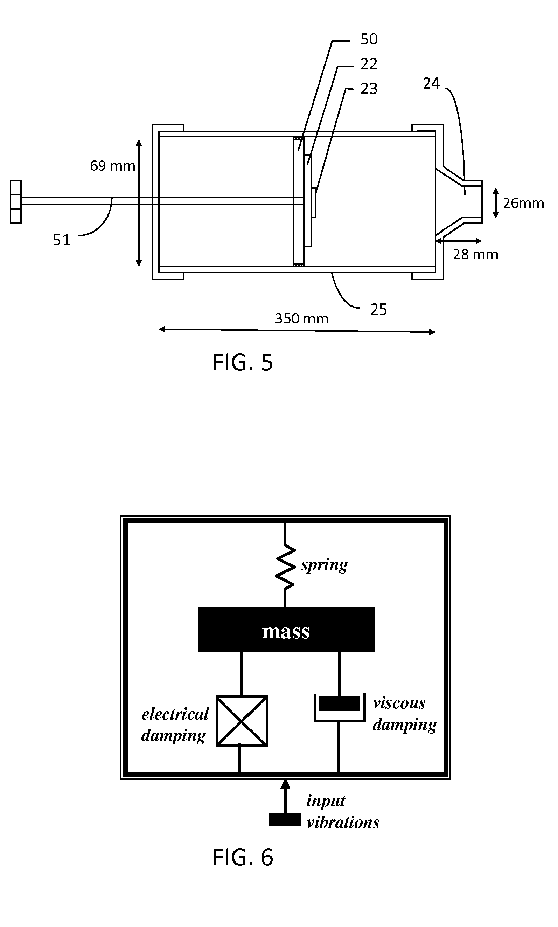

In accordance with embodiments of the present invention, the gasflow, e.g. airflow, harvester 20 with vibrational energy harvester 23 can work in an open air environment. In this case, the vibrational harvester 23 is used without packaging, in order for the pressure change to excite the vibrational harvester 23, e.g. the vibrational harvester beam 40 and mass 41, directly. The amplitude of vibration of the vibrational energy harvester 23 will be viscously damped by the ambient gas, e.g. air. FIG. 6 is a generic representation of a vibration energy harvester according to embodiments of the present invention. The harvester 23 consists of a spring, a mass that oscillates by the input vibrations, in accordance with embodiments of the present invention provided by the oscillations of the membrane 22, and two dampers that represent the mechanical and electrical damping. The mechanical damping emanates from the ambient gas, e.g. air.

In order to minimize the viscous damping and maximize the energy harvested by the vibrational energy harvester 23, e.g. piezoelectric device, in accordance with alternative embodiments of the present invention a packaged vibrational energy harvester 23, e.g. piezoelectric harvester, may be used. A vacuum-packaged or gas-packaged, e.g. air-packaged, vibrational energy harvester 23 may be used. The packaging may be provided for reliability and/or safety. A direct mounting of the vibrational energy harvester 23, e.g. piezoelectric device, on the bottom of the resonator 50 will impede and significantly reduce the excitation of the vibrational energy harvester 23, e.g. piezoelectric device. The amplitude of the excitation of the vibrational energy harvester 23 will depend only on the amplitude of oscillation of the contact surface between the Helmholtz resonator 21 and the vibrational energy harvester 23, e.g. piezoelectric device. In case of a very rigid material for the bottom of the resonator 21, the amplitude of vibration thereof, and hence the excitation of the vibrational energy harvester 23, will be very small, even null. To avoid this problem, the bottom of the Helmholtz resonator 21 in accordance with embodiments of the present invention may be complemented with a soft membrane or alternatively may be directly designed from such softer material, e.g. from a membrane 22, as illustrated in FIG. 4. The soft material may have spring constant much less, for example at least 20% less, e.g. at least 50% less, than the spring constant of the vibrational energy harvester 23, e.g. beam 40 of the piezoelectric device 23. The spring constant of the beam 40 is determined by design application. Hence the membrane 22 may form the bottom of the Helmholtz resonator 21, or may be part of the bottom of the Helmholtz resonator 21. The dimensions (e.g. radius) of the membrane 22 may be smaller than the corresponding dimensions (e.g. radius) of the bottom of the Helmholtz resonator 21. Alternatively, the dimensions (e.g. radius) of the bottom of the Helmholtz resonator 21 may be approximately equal or even equal to the corresponding dimensions (e.g. radius) of the membrane 22. In the embodiment illustrated in FIG. 4 the membrane 22 is provided at the bottom of the cavity 25 for efficiency reasons as set out above, and forms the bottom of the Helmholtz resonator 21.

When referring to FIG. 6, the amplitude of the membrane 22 is the external input to the vibration harvester, causing a casing of the vibration harvester to be moving periodically up and down with amplitude x as function of time (x(t)). The resulting movement of the mass (y(t)), will now be different from x(t). For enough power to be generated, a predetermined amplitude y(t) is required. Without the membrane 22, the external movement would be delivered by the gas, which means that the amplitude of the movement of the casing of the vibration harvester would be limited. To be more precise, in that case the bottom on which the harvester 23 is located might hardly move, so x(t) would be extremely small. Alternatively, gas pressure variations might directly move the proof mass, when the casing is open to the ambient, and then this provides the vibration y(t). This effect is not preferred at all. However, by using a membrane 22 and putting a casing of the harvester 23 on top of it so that the movement of the membrane and the movement of the harvester 23 are decoupled from one another as in accordance with embodiments of the present invention, an amplitude amplification effect is obtained: x(t) will now be far more greater, resulting in a larger y(t), and thus more power being generated.

The vibrational energy harvester 23 may have an area which is smaller than the area of the membrane 22. The area difference may be significant. This allows for miniaturization of the vibrational energy harvester 23.

In accordance with embodiments of the present invention, it is particularly advantageous if the vibrational energy harvester 23 has a resonance frequency and the membrane 22 onto which the vibrational energy harvester 23 is mounted moves at a frequency of the same value. If the membrane 22 starts to vibrate due to the Helmholtz resonance, it induces the movement of the mounted vibrational harvester 23. It is an advantage that a device for gasflow energy harvesting according to embodiments of the present invention can deliver more energy for a same amount of input gasflow, e.g. airflow, than prior art vibrational harvesters can. With preliminary measurements it has been possible to harvest up to 14.5 $\mu$W (2.1 V) at approximately 13 m/s airflow with a device according to embodiments of the present invention.

In particular embodiments of the present invention, a vibrational energy harvester 23 may be provided inside the Helmholtz resonator 21. The vibrational energy harvester 23 may be micromachined.

It is an advantage of embodiments of the present invention that a Helmholtz resonator may be combined with a piezoelectric harvester to harvest energy from gasflow, e.g. airflow.

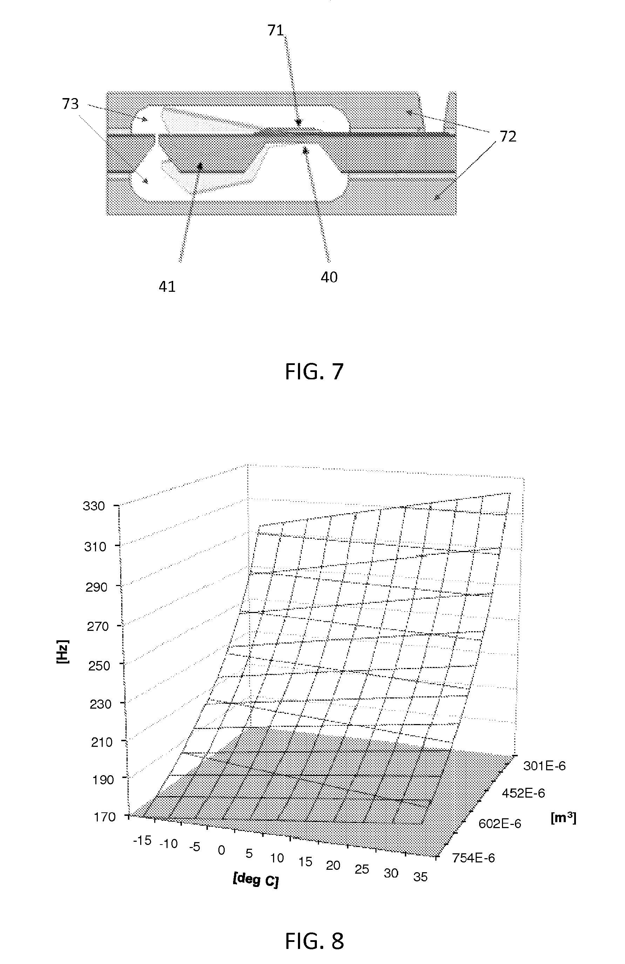

A major drawback of Helmholtz resonators is the strong dependence of their resonance frequency on the speed of sound in the gas used, e.g. air, thus on the gasflow temperature - see FIG. 8. In a limited temperature range of 10 degrees Centigrade the frequency shift is about 6 Hz, depending on the size of the resonator's cavity. This means that the application of the gasflow energy harvesters would be limited to environments with fairly stable temperature, like air-conditioning pipes. An option to overcome this is to use an automatic frequency tuning integrated with the piezoelectric cantilever energy harvester or multiple piezoelectric devices in the same resonator's cavity. Frequency tuning integrated with the piezoelectric cantilever energy harvester may be based on making use of the variable stiffness of the piezoelectric material, e.g. PZT. The stiffness of the piezoelectric material film as a combined tuning/harvesting layer or as a separate tuning layer can be adjusted by an externally applied field. Consequently the overall stiffness of the composite beam will change which leads to a change in the resonance frequency. The range of the tunable frequency depends on material parameters such as the thickness of the tuning layer, stiffness of the substrate, the order of the layers and possibly the design of the harvester.

Experiment

A Helmholtz resonator 21 with adjustable resonance frequency has been designed and complemented with a rubber membrane 22 on the bottom for better transmission of the airflow oscillations to the vibrational energy harvester 23, e.g. piezoelectric harvester. Such Helmholtz resonator 21 is schematically illustrated in FIG. 5.

In order to be able to adjust the resonance frequency of the Helmholtz resonator 21, it may be provided with an adjustable bottom 50. The bottom 50 can be a ring, which holds the membrane and allows the membrane to be moved freely up and down in the cavity 25. It is advantageous to provide a Helmholtz resonator with a tunable resonance frequency, as the maximum energy would be generated when the resonance frequency of the Helmholtz resonator and the resonance frequency of the piezoelectric harvester coincide. In the experiment, the resonator 21 was implemented as a tube, e.g. a plastic tube, with a piston 51 connected to the adjustable bottom 50 that can move back and forth allowing the volume of the cavity 25 to enlarge or become smaller. By adjusting the position of the bottom 50, the volume of the cavity 25 and hence the resonance frequency of the resonator 21 are adjusted.

For efficiency reasons, as illustrated in FIG. 3 , the vibrational energy harvester 23 is provided at the bottom of the cavity 25 of the Helmholtz resonator 21.

The vibrational energy harvester 23, e.g. piezoelectric energy converter, comprises a MEMS cantilever beam 40 with a seismic mass 41 attached to the free end of the beam 40, as shown on FIG. 7. This structure is fabricated from silicon by a combination of wet and dry etching techniques. A piezoelectric patch 71, consisting of a platinum bottom electrode, the piezoelectric material and a top aluminium electrode, is fabricated on top of the beam. The exact dimensions and thicknesses are question of design application. The harvesters were packaged in between two glass substrates 72. Cavities 73 were etched into these glass substrates 72 to allow the mass 41 to oscillate. Upon deflection of the cantilever 40 the mechanical strain causes charge separation inside the piezoelectric material and the generation of a voltage across the patch electrodes. Electrical power is dissipated, if a resistive load is connected to the patch 71.

Dimensions of the Helmholtz resonator 21 used in the experiment are illustrated in FIG. 5, the present invention, however, not being limited to resonators with these dimensions. At the bottom of the resonator a membrane 22 of stretched rubber with a diameter of 60 mm was mounted. For the rubber, a standard latex glove was used, with thickness of the rubber 0.10 mm, and tensile strength approximately 15MPa. The resonance frequency of the rubber membrane 22 was measured to be $f_{0m}$ = 40 Hz. Depending on the setting of the adjustable bottom 50, the resonator 21 was able to oscillate in the frequency range of 200 Hz to 500 Hz

On top of the rubber membrane 22, a piezoelectric harvester 23 was mounted. Different experiments with different vibrational harvesters 23 have been performed for mechanical testing:

    1. A glass packaged harvester of size 10 x 12 x 1 mm.
    2. A glass packaged harvester on a PCB. The PCB has size 45 x 45 mm.
    3. A glass packaged harvester on a PCB on a pedestal in the middle of the membrane. The pedestal has size 10 x 10 x 5 mm.

For the experiment, the gasflow stream was an airflow stream from a hairdryer. When set at maximum flow velocity, the air flow velocity was approximately 13 m/s. An acceleration on the surface of the membrane of 4.6 g (at 241 Hz) for option 1, 0 g (at 254 Hz) for option 2 and 7.4 g (at 230 Hz) for option 3 was achieved. The acceleration was detected visually, using a microscope to measure the displacement of the harvester 23.

The reason why no acceleration of the harvester 23 is noted in case of a harvester 23 mounted on a PCB an directly placed on the membrane 22 is that the surface of the PCB covers almost the whole of the membrane 22 and significantly reduces the resonating surface of the membrane 22. It is to be noted that the membrane 22 and the Helmholtz resonator 21 do not have to have the same resonance frequency.

For electrical testing, a piezoelectric harvester packaged in glass packaging filled with air as in case 1 of the mechanical testing was characterized to have a resonance frequency of 307 Hz. It can be noted that the resonance frequency of the membrane 22 and the piezoelectric cantilever do not have to coincide. For the proper operation of the gasflow harvester 20, only the resonance frequency of the Helmholtz resonator 21 and the vibrational energy harvester 23, e.g. piezoelectric cantilever, preferably match.

The maximum output power measured was around P =0.3 $\mu$W. Several measurements were performed whilst the harvester 23 was placed in the Helmholtz resonantor 21 (similar to case 3 of the mechanical testing). The results are given in the table below:

| $f_0$ Helmholtz | $R_{load}$ | $V_{meas}$ | $I_{meas}$ | P |
|---|---|---|---|---|
| Hz | Ohm | V | $\mu$A | $\mu$W |
| 307 | 100k | 0.15 | - | 0.22 |
| 310 | 1M | - | 0.5 | 0.25 |
| 310 | 3.3M | - | 0.3 | 0.29 |

The membrane 22 enhances the vibration of the cantilever so that the cantilever exceeds its deflection maximum. So even if the Helmholtz resonance frequency is slightly off the resonance frequency of the cantilever, the piezodevice can provide its maximum power. If power vs. frequency is plotted, the curve will have a broad plateau around the resonance frequency with maximum value. That maximum is physically determined/limited by the glass packaging of the device. (i.e. the device hits the packaging)

Two principles of measuring the power have been used - via current or via voltage across the electrical load resistor Rload of the piezoelectric harvester. The current measurement is more accurate. The third row uses the optimum Rload for the piezoelectric device, so the power harvested is the highest. Rload is connected externally to the piezoelectric harvester.

The harvester was not a vacuum-packaged device. It is advantageous that a piezoelectric harvester in air packaging is used because the accelerations measured on the membrane were destructively high for a vacuum-packaged device.

The maximum power which the device could deliver was determined during characterization to be around P = 0.3 $\mu$W, which was due to the ageing of the device at the time of the measurements.

With the above experiment, proof of principle is presented. The devices used in measurements were not optimized for the specific application If this would be the case, power output would easily increase towards 100 $\mu$W and higher.

While the invention has been illustrated and described in detail in the drawings and foregoing description, such illustration and description are to be considered illustrative or exemplary and not restrictive. The invention is not limited to the disclosed embodiments.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage.

**Claims**

1. A device (20) for gasflow energy harvesting, comprising
   a cavity resonator (21) comprising a membrane (22) for converting gasflow in vibration, and
   a vibrational energy harvester (23) for converting the converted vibration into electrical energy,
   wherein the device (20) for gasflow energy harvesting is adapted such that the movement of the vibrational energy harvester (23) is decoupled from the movement of the membrane (22).

2. A device (20) for gasflow energy harvesting according to claim 1, wherein the movement of the vibrational energy harvester (23) is decoupled from the movement of the membrane (22) by mounting a separately movable vibrational energy harvester (23) on the membrane (22) of the cavity resonator (21).

3. A device (20) for gasflow energy harvesting according to any of the previous claims, wherein the movement of the vibrational energy harvester (23) is decoupled from the movement of the membrane (22) such that the amplitude of the movement of the membrane (22) may be different from the amplitude of the movement of the vibrational energy harvester (23).

4. A device (20) for gasflow energy harvesting according to any of the previous claims, wherein the vibrational energy harvester (23) is a piezoelectric harvester.

5. A device (20) for gasflow energy harvesting according to claim 4, wherein the piezoelectric harvester is vacuum packaged or gas-packaged.

6. A device (20) for gasflow energy harvesting according to any of the previous claims, wherein the vibrational energy harvester comprises a cantilever beam.

7. A device (20) for gasflow energy harvesting according to claim 6, wherein the cantilever beam is made of or covered with piezoelectric material.

8. A device (20) for gasflow energy harvesting according to any of the previous claims, wherein the vibrational energy harvester (23) and the cavity resonator (21) have a similar resonance frequency.

9. A device (20) for gasflow energy harvesting according to claim 8, wherein the cavity resonator (21) and the vibrational energy harvester (23) are adapted to operate at matched resonance frequency.

10. A device (20) for gasflow energy harvesting according to any of the previous claims, wherein the cavity resonator is adapted for having an adjustable resonance frequency.

11. A device (20) for gasflow energy harvesting according to claim 10, the cavity resonator (21) having a cavity (25), wherein the cavity resonator (21) is adapted for changing the volume of the cavity (25).

12. A device (20) for gasflow energy harvesting according to any of the previous claims, wherein the vibrational energy harvester (23) is a MEMS device.

13. A device (20) for gasflow energy harvesting according to claim 12, wherein the vibrational harvester (23) is an AIN piezoelectric harvester on the membrane (22).

14. A device (20) for gasflow energy harvesting according to any of the previous claims, wherein the cavity resonator is a Helmholtz resonator.

15. A method for harvesting energy from a gasflow by means of a vibrational energy harvester (23), the method comprising converting the gasflow into vibrations of gas in a cavity (25), and
actuating the vibrational energy harvester (23) by means of the vibrations of gas in the cavity (25),
wherein actuating the vibrational energy harvester (23) is such that the amplitude of the movement of the vibrational energy harvester (23) is decoupled from the amplitude of the movement of the gas vibrations.

10

air jet

12

air at atmospheric pressure

12

inside air compressed

11

m

s

(a)                              (b)                              (c)

FIG. 1

Air flow

24

20

Pressure change

25

23

21

22

FIG. 2

**309 Hz**

FIG. 3

FIG. 4

50

22

23

24

69 mm

26mm

51

28 mm

350 mm

25

FIG. 5

spring

mass

electrical
damping

viscous
damping

input
vibrations

FIG. 6

FIG. 7

FIG. 8

Europäisches
Patentamt

European
Patent Office

Office européen
des brevets

# EUROPEAN SEARCH REPORT

Application Number

EP 10 16 7267

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2006/022555 A1 (BALASUBRAMANIAM MAHADEVAN [US] ET AL BALASUBRAMANIAM MAHADEVAN [US] ET) 2 February 2006 (2006-02-02) * paragraph [0028] - paragraph [0035] * * figures 2-5 * | 1-15 | INV. B06B1/00 H01L41/113 |
| X | US 4 467 236 A (KOLM HENRY H [US] ET AL) 21 August 1984 (1984-08-21) * column 4, line 3 - line 34 * | 1,15 | |
| A | WO 2006/046937 A1 (MICHELIN SOC TECH [FR]; MICHELIN RECH TECH [CH]; THIESEN JACK [US]; O') 4 May 2006 (2006-05-04) * paragraph [0039] - paragraph [0043] * * figures 1,2 * | 1-15 | |
| A | US 3 748 502 A (BERNSTEIN J) 24 July 1973 (1973-07-24) * column 1, line 51 - column 3, line 51 * * figure 1 * | 1-15 | |

TECHNICAL FIELDS SEARCHED (IPC)

B06B
H01L

The present search report has been drawn up for all claims

| Place of search | Date of completion of the search | Examiner |
|---|---|---|
| Munich | 1 December 2010 | Marquart, N |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
...........................................................................
& : member of the same patent family, corresponding
document

EPO FORM 1503 03.82 (P04C01)

**ANNEX TO THE EUROPEAN SEARCH REPORT
ON EUROPEAN PATENT APPLICATION NO.**                    EP 10 16 7267

This annex lists the patent family members relating to the patent documents cited in the above-mentioned European search report.
The members are as contained in the European Patent Office EDP file on
The European Patent Office is in no way liable for these particulars which are merely given for the purpose of information.

01-12-2010

| Patent document cited in search report | | Publication date | Patent family member(s) | | Publication date |
|---|---|---|---|---|---|
| US 2006022555 | A1 | 02-02-2006 | NONE | | |
| US 4467236 | A | 21-08-1984 | NONE | | |
| WO 2006046937 | A1 | 04-05-2006 | CN | 101002343 A | 18-07-2007 |
| | | | EP | 1803170 A1 | 04-07-2007 |
| | | | JP | 2008518573 T | 29-05-2008 |
| | | | US | 2008129147 A1 | 05-06-2008 |
| US 3748502 | A | 24-07-1973 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2006022555 A

### Non-patent literature cited in the description

- **D. O. LUDWIGSEN et al.** Better Understanding of Resonance through Modeling and Visualisation. *Proceedings of the COMSOL Users Conference,* 2006

- **D.O. LUDWIGSEN et al.** Better understanding of resonance through modeling and visualization. *Proceedings of the COMSOL Users Conference,* 2006